# EUROPÄISCHE PATENTSCHRIFT

(11) **EP 1 236 281 B1**
(45) Veröffentlichungstag und Bekanntmachung des Hinweises auf die Patenterteilung: **25.06.2003**
(21) Anmeldenummer: 00993361.5
(22) Anmeldetag: 04.12.2000
(51) Int. Cl.: H03M 13/29, H04L 1/00, H04L 25/03

(54) **TURBO-CODE-DECODER UND TURBO-CODE-DECODIERVERFAHREN MIT ITERATIVER KANALPARAMETERSCHÄTZUNG**
TURBO CODE DECODER AND TURBO CODE DECODING METHOD WITH ITERATIVE CHANNEL PARAMETER ESTIMATION
DECODEUR DE CODE TURBO ET PROCEDE DE DECODAGE DE CODE TURBO A ESTIMATION ITERATIVE DES PARAMETRES DE CANAUX

(30) Priorität: 09.12.1999 DE 19959409
(43) Veröffentlichungstag der Anmeldung: 04.09.2002
(73) Patentinhaber: Infineon Technologies AG, 81669 München (DE)
(72) Erfinder: DOETSCH, Markus, 56072 Koblenz-Rübenach (DE); JUNG, Peter, 67697 Otterberg (DE); KELLA, Tideya, 80337 München (DE); PLECHINGER, Jörg, 80469 München (DE); SCHMIDT, Peter, 67167 Erpolzheim (DE); SCHNEIDER, Michael, 81541 München (DE)
(74) Vertreter: Graf Lambsdorff, Matthias, Dr.
(86) Internationale Anmeldenummer: DE0004328
(87) Internationale Veröffentlichungsnummer: WO01043290

(56) Entgegenhaltungen:
- WO-A-99/09696
- DE-A- 19 902 100
- US-A- 5 265 122
- US-A- 5 905 742
- US-A- 5 907 582
- US-A- 6 094 427

## Beschreibung

Die Erfindung betrifft einen Turbo-Code-Decoder und ein Turbo-Code-Decodierverfahren mit iterativer Kanalparameterschätzung, insbesondere für den Mobilfunkbereich.

Zur Kanalcodierung werden in jüngster Zeit binäre, parallel verkettete, rekursive systematische Faltungscodes eingesetzt, die man als Turbo-Codes bezeichnet. Durch die Verwendung von Turbo-Codes anstelle von Faltungscodes läßt sich insbesondere beim Übertragen von großen Blöcken von Datenbits ein erheblich besserer Fehlerschutz erzielen. Die dem Turbo-Code zugrundeliegende Idee besteht in dem Verketten von mindestens zwei binären, rekursiven systematischen Faltungscodierern bzw. RSC-Codierern unter Verwendung von Turbo-Code-Verschachtelungseinrichtungen. Die RSC-Codierer erzeugen redundante Datenfolgen. Die Verschachtelung der Codierung durch die Codierer erfolgt in dem Turbo-Codierer blockweise. Die Ausgangsdatenfolge des Turbo-Codierers enthält die ursprüngliche Eingangsdatenfolge als systematische Information und zusätzlich die redundanten Daten als nicht-systematische Information. Der Aufbau eines herkömmlichen Codierers ist beispielsweise in "Analyse und Entwurf digitaler Mobilfunksysteme" von Dr. Peter Jung, Teubner Verlag, Stuttgart, 1997, S. 334-348 eingehend beschrieben.

Weiterhin zeigt die US-Patentschrift 5 907 582 einen Turbo-Code Decodierer mit einer Schwellwert - Entscheidungsschaltung.

Die turbo-codierten Daten werden'von einem Sender abgegeben und gelangen über einen Datenkanal zu einem Empfänger, der einen Turbo-Code-Decodierer enthält. Der Turbo-Code-Decodierer macht die in dem Turbo-Codierer erfolgte Codierung rückgängig und gibt Empfangsdatenschätzwerte ab, die möglichst genau der ursprünglichen, durch den Turbo-Code-Codierer codierten Datenfolge entsprechen sollen.

Der Datenübertragungskanal bzw. die Kanalstrecke ist jedoch nicht stabil, sondern unterliegt Schwankungen. Anhand der empfangenen Daten ist es möglich, den Kanalzustand des Datenübertragungskanals zu schätzen. Dabei werden bestimmte Kanalparameter bestimmt. Je genauer der Zustand des Übertragungskanals eingeschätzt wird, desto geringer ist das Bitfehlerverhältnis.

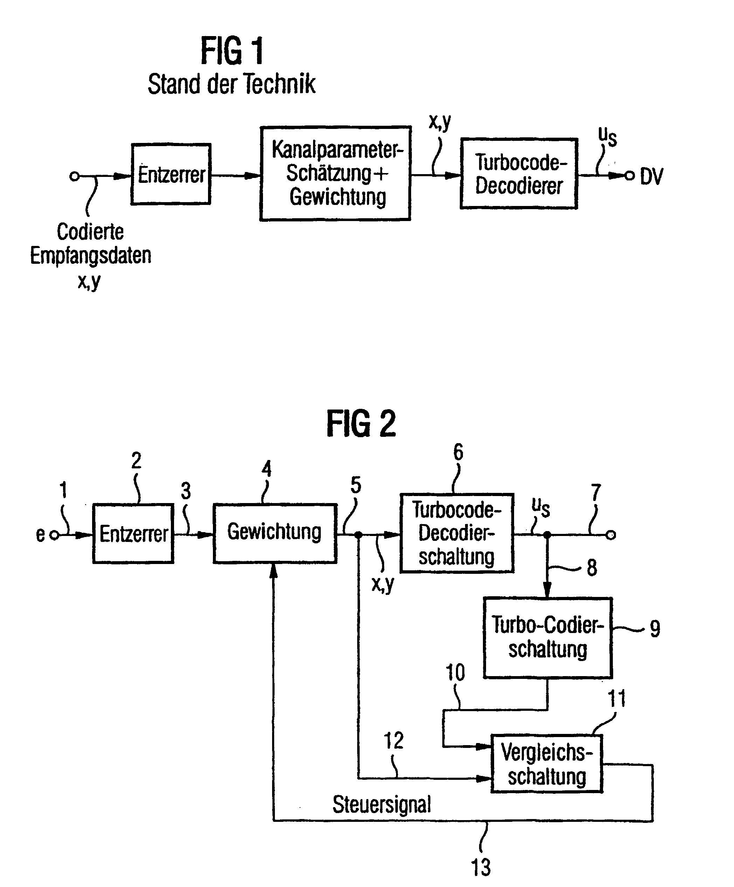

Fig. 1 zeigt den Aufbau einer Turbo-Code-Empfangsschaltung nach dem Stand der Technik.

Die turbo-codierten Empfangsdaten enthalten systematische Informationsdaten x sowie redundante Daten y. Die codierten Empfangsdaten werden einem Entzerrer zugeführt, die die entzerrten turbo-codierten Empfangsdaten an eine Schaltung zur Kanalparameterschätzung abgibt, der die entzerrten turbo-codierten Empfangsdaten in Abhängigkeit von den ermittelten Kanalparametern gewichtet und an einen Turbo-Code-Decodierer abgibt. Der Turbo-Code-Codierer führt die Turbo-Decodierung der gewichteten, systematischen und redundanten Empfangsdaten durch und gibt eine Schätzwertdatenfolge zur weiteren Datenverarbeitung ab.

Das Problem bei der in Fig. 1 gezeigten Anordnung besteht darin, daß durch die Schaltung zur Kanalparameterschätzung und Gewichtung der Empfangsdaten lediglich ein einziges Mal pro empfangenem Datenblock eine Kanalparameterschätzung erfolgt. Da der Übertragungskanal insbesondere im Mobilfunkbereich aufgrund von Störeinflüssen jedoch stark schwanken kann, sind die ermittelten Kanalparameterschätzwerte so ungenau, daß sie bei Verwendung in dem Turbo-Code-Decodierer zu einem unzureichenden Systemverhalten führen, wodurch die Bitfehlerrate ansteigt.

Es ist daher die Aufgabe der vorliegenden Erfindung, einen Turbo-Code-Decodierer sowie ein Turbo-Code-Decodierverfahren zu schaffen, bei dem die Kanalparameter iterativ ständig neu geschätzt werden, um auf Schwankungen des Übertragungskanals schnell zu reagieren und somit die Bitfehlerrate zu senken.

Diese Aufgabe wird erfindungsgemäß durch einen Turbo-Code-Decodierer mit den im Patentanspruch 1 angegebenen Merkmalen sowie durch ein Verfahren mit den im Patentanspruch 7 angegebenen Merkmalen gelöst.

Weitere vorteilhafte Ausgestaltungen der Erfindung ergeben sich aus den Unteransprüchen.

Die Erfindung schafft einen Turbo-Code-Decodierer mit iterativer Kanalschätzung zur Decodierung von turbo-codierten Empfangsdaten, die systematische Informationsdaten und redundante Daten umfassen, mit:
(a) einer Gewichtungsschaltung zur Gewichtung der turbo-codierten Empfangsdaten mit mindestens einem geschätzten Kanalparameter;
(b) einem ersten Kanaldecodierer zur Erzeugung von Zuverlässigkeitsinformationsdaten in Abhängigkeit der empfangenen systematischen Informationsdaten, einer ersten Redundanzdatenfolge und einer extrinsischen Informationsdatenfolge;
(c) einem Turbo-Code-Verschachteler zur Verschachtelung der erzeugten Zuverlässigkeitsinformationsdaten;
(d) einem zweiten Kanaldecodierer zur Erzeugung der extrinsischen Informationsdatenfolge, die durch einen ersten Turbo-Code-Entschachteler entschachtelt an den ersten Kanaldecodierer rückgekoppelt wird, und zur Erzeugung von Wahrscheinlichkeitsverhältnisdaten, die durch einen zweiten Turbo-Code-Entschachteler entschachtelt an einen Schwellwert-Entscheider zur Generierung von Schätzwertdaten abgegeben werden, wobei die Erzeugung der extrinsischen Informationsdatenfolge und der Wahrscheinlichkeitsverhältnisdaten in Abhängigkeit von den verschachtelten Zuverlässigkeitsinformationsdaten und einer zweiten Redundanzdatenfolge erfolgt,
(e) einer Turbo-Codierschaltung zur Turbo-Codierung der generierten Schätzwertdaten; und mit
(f) einer Vergleichsschaltung, die die turbo-codierten Schätzwertdaten mit den turbo-codierten Empfangsdaten vergleicht und in Abhängigkeit von dem Vergleichsergebnis die geschätzten Kanalparameter zur Gewichtung der turbo-codierten Empfangsdaten iterativ einstellt.

Bei einer bevorzugten Weiterbildung des erfindungsgemäßen Turbo-Code-Decoders weist dieser eine Datentrennungseinrichtung zur Trennung der Empfangsdaten in eine systematische Informationsdatenfolge und in mehrere Redundanzdatenfolgen auf.

Vorzugsweise weist die Datentrenneinrichtung einen Multiplexer auf, der die erste Redundanzdatenfolge an den ersten Kanaicodierer und die zweite Redundanzdatenfolge an den zweiten Kanalcodierer abgibt.

Bei einer bevorzugten Weiterbildung ist ein Zwischenspeicher zum Zwischenspeichern in der zweiten Redundanzdatenfolge vorgesehen.

Die Turbo-Codierschaltung besteht vorzugsweise aus mehreren RSC-Codierern mit nachgeschalteten Punktierungseinrichtungen, mindestens einem Turbo-Code-Verschachteler sowie einem Multiplexer.

Die geschätzten Kanalparameter umfassen vorzugsweise das Signalrauschverhältnis des Kanals.
Das erfindungsgemäße Decodierverfahren zur Decodierung von turbo-codierten Empfangsdaten umfaßt die folgenden Schritte, nämlich
(a) Gewichten der turbo-codierten Empfangsdaten mit mindestens einem geschätzten Kanalparameter;
(b) Erzeugen von Zuverlässigkeitsinformationsdaten in Abhängigkeit von empfangenen systematischen Informationsdaten, einer ersten Redundanzdatenfolge und einer extrinsischen entschachtelten Informationsdatenfolge;
(c) Verschachteln der erzeugten Zuverlässigkeitsinformationsdaten;
(d) Erzeugen von extrinsischen Informationsdaten in Abhängigkeit von den verschachtelten Zuverlässigkeitsinformationsdaten und einer zweiten Redundanzdatenfolge, wobei die erzeugte extrinsische Informationsdatenfolge durch einen Turbo-Code-Entschachteler entschachtelt an den ersten Kanaldecodierer rückgekoppelt wird;
(e) Erzeugen von Wahrscheinlichkeitsverhältnisdaten in Abhängigkeit von den verschachtelten Zuverlässigkeitsinformationsdaten sowie der zweiten Redundanzdatenfolge;
(f) Entschachteln der Wahrscheinlichkeitsverhältnisdaten;
(g) Bilden von Schätzwertdaten durch Schwellenwertentscheidung;
(h) Turbo-Codieren der gebildeten Schätzwertdaten;
(i) Vergleichen der turbo-codierten Schätzwertdaten mit den Empfangsdaten;
(j) Einstellen der geschätzten Kanalparameter in Abhängigkeit von den verglichenen turbo-codierten Schätzdaten sowie den Empfangsdaten.

Im weiteren werden bevorzugte Ausführungsformen des erfindungsgemäßen Turbo-Code-Decodierers sowie des erfindungsgemäßen Turbo-Code-Decodierverfahrens mit iterativer Kanalparameterschätzung unter Bezugnahme auf die beigefügten Zeichnungen zur Erläuterung erfindungswesentlicher Merkmale beschrieben. Es zeigen:
Fig. 1 eine Turbo-Code-Empfangsschaltungsanordnung nach dem Stand der Technik;
Fig. 2 eine Turbo-Code-Empfangsanordnung gemäß der vorliegenden Erfindung;
Fig. 3 die in Fig. 2 dargestellte erfindungsgemäße Turbo-Code-Decodierschaltung im Detail;
Fig. 4 die in Fig. 2 dargestellte Turbo-Code-Codierschaltung im Detail.

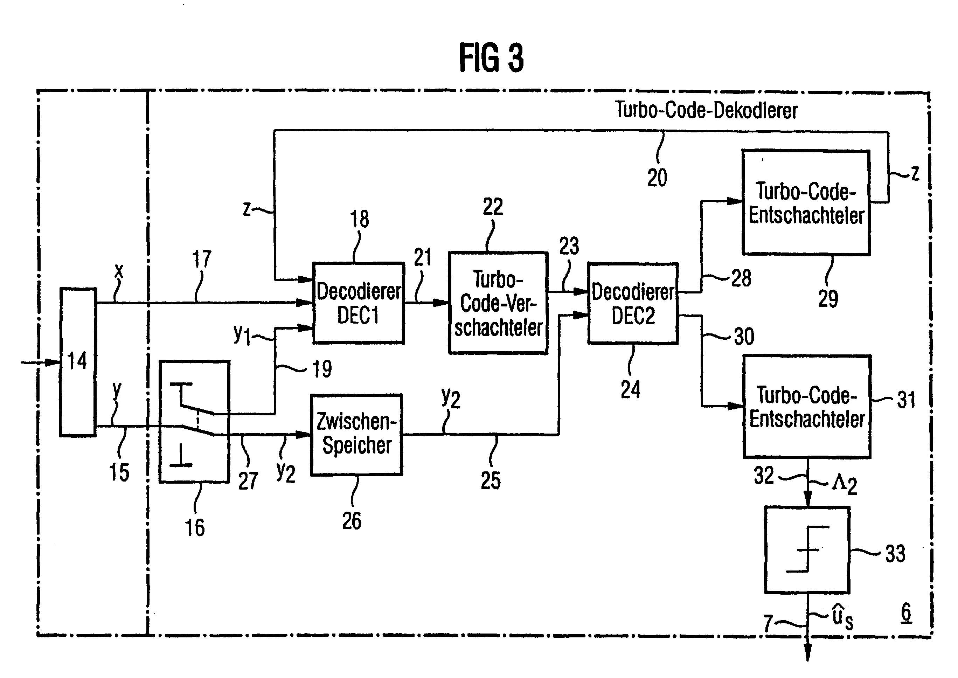

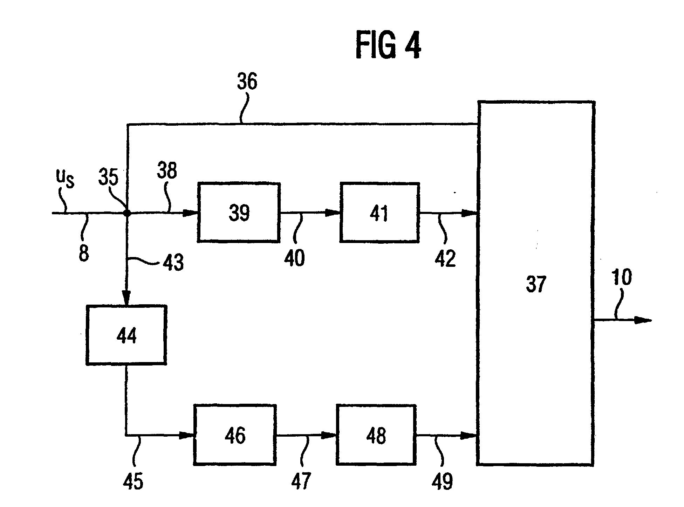

Wie man aus Fig. 2 erkennen kann, wird eine beispielsweise über eine Antenne empfangene und demodulierte turbo-codierte Empfangsdatenfolge über eine Leitung 1 einem Entzerrer 2 zugeführt. Der Entzerrer 2 entzerrt die Empfangsdatenfolge und gibt sie über eine interne Leitung 3 an eine Gewichtungsschaltung 4 zur Gewichtung der turbo-codierten Empfangsdaten mit mindestens einem geschätzten Kanalparameter ab. Die gewichteten turbo-codierten Empfangsdaten gelangen über interne Leitungen 5 in eine Turbo-Code-Decodierschaltung 6, in der sie zunächst durch eine Datentrennschaltung in eine systematische Informationsdatenfolge und mehrere Redundanzdatenfolgen getrennt werden. Die Turbo-Code-Decodierschaltung wird nachfolgend im Detail unter Bezugnahme auf die Fig. 3 beschrieben. Die Turbo-Code-Decodierschaltung 6 führt die eigentliche Turbo-Code-Decodierung durch und gibt eine Schätzwertdatenfolge über eine Leitung 7 zur weiteren Datenverarbeitung innerhalb des Empfängers ab. Die Schätzwertdatenfolge wird über eine Leitung 8 zusätzlich an eine Turbo-Code-Codierschaltung 9 abgezweigt. Die Turbo-Code-Codierschaltung 9 wird im weiteren unter Bezugnahme auf die Fig. 4 im Detail beschrieben. Die Turbo-Code-Codierschaltung 9 codiert die durch die Turbo-Code-Decodierschaltung 6 erzeugten Schätzwertdaten und gibt die derart turbo-codierten Schätzwertdaten über eine interne Leitung 10 an eine Vergleichsschaltung 11 ab. Die Vergleichsschaltung 11 erhält über eine Leitung 12 zusätzlich die ursprünglichen, gewichteten, turbo-codierten Empfangsdaten vom Ausgang der Gewichtungsschaltung 4. Die Vergleichsschaltung 11 vergleicht die gewichteten ursprünglichen turbo-codierten Empfangsdaten mit den an der Leitung 10 anliegenden turbo-codierten Schätzwertdaten. In Abhängigkeit von dem Vergleichsergebnis stellt die Vergleichsschaltung über eine Steuerleitung 13 iterativ die Kanalparameter ein. Die in der Gewichtungsschaltung 4 zur Gewichtung eingesetzten Kanalparameter werden auf diese Weise ständig nachgeregelt, so daß sie auch bei starken Schwankungen des Datenübertragungskanals ständig den Kanalzustand genau wiedergeben. Hierdurch nimmt das Bitfehlerverhältnis bei dem erfindungsgemäßen Turbo-Code-Decodierer stark ab. Als Kanalparameter verwendet man vorzugsweise das Signalrauschverhältnis bzw. SNR-Verhältnis des Übertragungskanals.

Fig. 3 zeigt die in Fig. 2 dargestellte Turbo-Code-Decodierschaltung 6 im Detail. Eine Datenfolgen-Trenneinrichtungsschaltung 14 trennt die an der Leitung 5 anliegenden gewichteten, turbo-codierten Empfangsdaten in eine systematische Informationsdatenfolge x und in redundante Daten y auf. Die redundanten Daten y werden über eine Leitung 15 einer weiteren Datenfolgen-Trenneinrichtung 16, beispielsweise einem Multiplexer, zugeführt, der die redundanten Daten bei der in Fig. 3 gezeigten bevorzugten Ausführungsform in eine erste Redundanzdatenfolge und eine zweite Redundanzdatenfolge durch Umschalten trennt. Die systematische Informationsdatenfolge x gelangt über eine interne Leitung 17 zu einem ersten Kanaldecodierer 18. Der erste Kanaldecodierer 18 erhält über eine Leitung 19 die erste Redundanzdatenfolge y₁. Ferner erhält der erste Kanaldecodierer 18 über eine Rückkopplungsleitung 20 eine extrinsische Informationsdatenfolge z. Die extrinsische Informationsdatenfolge z hängt wie die systematische Informationsdatenfolge x nur von systematischen Informationen innerhalb des Empfangssignals ab. Der erste Kanaldecodierer 18 erzeugt eine Folge von Zuverlässigkeitsinformationsdaten in Abhängigkeit der empfangenen systematischen Informationsdaten x, der ersten redundanten Datenfolge y₁ sowie der Folge von entschachtelten extrinsischen Informationsdaten z. Die so erzeugten Zuverlässigkeitsinformationsdaten spiegeln die Zuverlässigkeit der empfangenen turbo-codierten Daten wider. Die erzeugten Zuverlässigkeitsinformationsdaten gelangen über eine Leitung 21 zu einem Turbo-Code-Verschachteler 22 zur Verschachtelung der erzeugten Zuverlässigkeitsinformationsdaten. Die derart verschachtelten Zuverlässigkeitsinformationsdaten werden über eine interne Leitung 23 einem zweiten Kanaldecodierer 24 zugeführt. Dieser erhält an einem weiteren Eingang über eine Leitung 25 die zweite Redundanzdatenfolge y₂ aus einem Zwischenspeicher 26. Der Zwischenspeicher 26 ist eingangsseitig über eine Leitung 27 mit dem Multiplexer 16 verbunden.

Der zweite Kanaldecodierer 24 erzeugt einerseits die extrinsische Informationsdatenfolge z, die er über eine Ausgangsleitung 28 an einen Turbo-Code-Entschachteler 29 zur Entschachtelung abgibt. Der Turbo-Code-Entschachteler 29 entschachtelt die durch den zweiten Kanaldecodierer gebildete extrinsische Informationsdatenfolge, koppelt sie über die Rückkopplungsleitung 20 an den ersten Kanaldecodierer 18 zurück. Die in dem zweiten Kanaldecodierer 24 gebildete extrinsische Informationsdatenfolge z wird in Abhängigkeit von der an der Leitung 23 anliegenden verschachtelten Zuverlässigkeitsinformationsdatenfolge und der an der Leitung 25 anliegenden zweiten Redundanzdatenfolge y₂ gebildet.

Der zweite Kanaldecodierer 24 erzeugt ferner eine Reihe von Wahrscheinlichkeitsverhältnisdaten, sogenannten Loglikelihood-ratio-Daten (LLR-Daten), in Abhängigkeit von den an der Leitungen 23 anliegenden verschachtelten Zuverlässigkeitsinformationsdaten und der zweiten Redundanzdatenfolge y₂, die aus dem Zwischenspeicher 26 ausgelesen wird. Die Wahrscheinlichkeitsverhältnisdaten werden über eine Leitung 30 an einen Turbo-Code-Entschachteler 31 abgegeben, der ausgangsseitig über eine Leitung 32 mit einer Schwellwert-Entscheidungsschaltung 33 verbunden ist. Die Schwellwert-Entscheidungsschaltung ermittelt aus den erhaltenen Wahrscheinlichkeitsverhältnisdaten bzw. LLR-Daten eine Schätzwertdatenfolge, die über eine Leitung 7 zur weiteren Datenverarbeitung in dem Empfänger abgegeben wird. Die LLR-Daten sind Maße für die Zuverlässigkeit einer getroffenen Entscheidung bezüglich der gesendeten binären Datensymbole. Die Erzeugung der extrinsischen Informationsdatenfolge z und der Wahrscheinlichkeitsverhältnisdaten durch den zweiten Kanaldecodierer 24 in Abhängigkeit von den verschachtelten Zuverlässigkeitsinformationsdaten und der zweiten Redundanzdatenfolge y₂ wird in P. Jung, "Analyse und Entwurf digitaler Mobilfunksysteme", Teubner Verlag, Stuttgart, unter E.3 auf den Seiten 348-361 im einzelnen beschrieben.

Die von der Schwellwert-Entscheidungsschaltung 33 abgegebenen Schätzwerte Uₛ werden der in Fig. 2 gezeigten Turbo-Code-Codierschaltung 9 über die Leitungen 7, 8 zugeführt. Die Turbo-Code-Codierschaltung 9 ist in Fig. 4 detailliert gezeigt. Die Turbo-Code-Codierschaltung 9 entspricht einem herkömmlichen Turbo-Codierer. Die Schätzwerte Uₛ werden an einem Verzweigungspunkt 35 verzweigt und gelangen über eine Leitung 36 zu einem ersten Eingang eines Multiplexers 37. Die Schätzwerte werden ferner über eine interne Leitung 38 einem RSC-Codierer 39 zugeführt. Der RSC-Codierer 39 erzeugt redundante codierte Daten, die über eine Leitung 40 zu einer Punktierungsschaltung 41 gelangen. Die Punktierungsschaltung 41 punktiert die durch den ersten RSC-Codierer 39 codierten Daten und gibt die punktierte Datenfolge an einen zweiten Eingang des Multiplexers 37 über eine Leitung 42 ab.

Die am Verzweigungsknoten 35 anliegenden erzeugten Schätzdaten werden über eine Leitung 43 an einen Turbo-Code-Verschachteler 44 angelegt, der ausgangsseitig über eine interne Leitung 45 mit einem zweiten RSC-Codierer 46 verbunden ist. Der RSC-Codierer 46 führt als binärer, rekursiver, systematischer Faltungscodierer eine Codierung der durch den Turbo-Code-Verschachteler 44 verschachtelten Schätzdaten durch zur Erzeugung einer codierten Datenfolge, die über eine Leitung 47 an eine Punktierungsschaltung 48 zur Punktierung abgegeben wird. Die Punktierungsschaltung 48 ist ausgangsseitig über eine Leitung 49 mit einem dritten Eingang des Multiplexers 37 verbunden. Die Turbo-Code-Codierschaltung 9 innerhalb des Empfängers, wie sie in dem erfindungsgemäßen Turbo-Code-Decodierer gemäß der Erfindung enthalten ist, funktioniert genauso wie ein in dem Sender eingebauter Turbo-Codierer. Die genaue Funktionsweise eines derartigen Turbo-Codierers wird in P. Jung, "Analyse und Entwurf digitaler Mobilfunksysteme", unter D.2 auf den Seiten 343-348 beschrieben. Der Multiplexer 37 der Turbo-Codierschaltung 9 erzeugt ausgangsseitig eine Folge turbo-codierter Schätzwertdaten, die der in Fig. 2 dargestellten Vergleichsschaltung 11 über die Leitung 10 zugeführt werden. Die Vergleichsschaltung 11 vergleicht dann die turbo-codierten Empfangsdaten mit den ursprünglichen turbo-codierten Empfangsdaten, die am Eingang der Turbo-Code-Decodierschaltung 6 anliegen. In Abhängigkeit von dem Vergleichsergebnis werden die geschätzten Kanalparameter des Übertragungskanals zur Gewichtung der turbo-codierten Empfangsdaten innerhalb der Gewichtungsschaltung 4 eingestellt bzw. geregelt. Da nach jeder Decodier-Iteration die Kanalparameter unter Verwendung der decodierten und sodann wieder codierten Datenbits bzw. Symbole ermittelt werden, wird der Kanalzustand auch bei starken Veränderungen des Übertragungskanals schnell angepaßt, so daß das dynamische Systemverhalten erheblich verbessert wird. Hierdurch kann durch den erfindungsgemäßen Turbo-Code-Decoder ein erheblich geringerers Bitfehlerverhältnis erreicht werden. Der erfindungsgemäße Turbo-Code-Decoder eignet sich daher hervorragend im Mobilfunkbereich, insbesondere bei UMTS, IS-95/IS-2000, WCDMA und dergleichen.

## Patentansprüche

1. Turbo-Code-Decodierer mit iterativer Kanalparameterschätzung zur Decodierung von turbo-codierten Empfangsdaten, die systematische Informationsdaten und redundante Daten umfassen, mit:
(a) einer Gewichtungsschaltung (4) zur Gewichtung der turbo-codierten Empfangsdaten mit mindestens einem geschätzten Kanalparameter;
(b) einem ersten Kanaldecodierer (18) zur Erzeugung von Zuverlässigkeitsinformationsdaten in Abhängigkeit der empfangenen systematischen Informationsdaten (x), einer ersten Redundanzdatenfolge (y₁) und einer entschachtelten extrinsischen Informationsdatenfolge (z) ;
(c) einem Turbo-Code-Verschachteler (22) zur Verschachtelung der erzeugten Zuverlässigkeitsinformationsdaten;
(d) einem zweiten Kanaldecodierer (24) zur Erzeugung der extrinsischen Informationsdatenfolge (z), die durch einen ersten Turbo-Code-Entschachteler (29) entschachtelt an den ersten Kanaldecodierer (18) rückgekoppelt wird, und zur Erzeugung von Wahrscheinlichkeitsverhältnisdaten, die durch einen zweiten Turbo-Code-Entschachteler (31) entschachtelt an eine Schwellenwert-Entscheidungsschaltung (33) zur Generierung von Schätzwertdaten abgegeben werden, wobei die Erzeugung der extrinsischen Informationsdatenfolge (z) und der Wahrscheinlichkeitsverhältnisdaten in Abhängigkeit von den verschachtelten Zuverlässigkeitsinformationsdaten und einer zweiten Redundanzdatenfolge (y₂) erfolgt;
(e) einer Turbo-Code-Codierschaltung (9) zur Turbo-Codierung der generierten Schätzwertdaten;
(f) und mit einer Vergleichsschaltung (11), die die turbo-codierten Schätzwertdaten mit den turbo-codierten Empfangsdaten vergleicht und in Abhängigkeit von dem Vergleichsergebnis die geschätzten Kanalparameter zur Gewichtung der turbo-codierten Empfangsdaten iterativ einstellt.

2. Turbo-Code-Decoder nach Anspruch 1,
**dadurch gekennzeichnet,**
**daß** eine Datentrenneinrichtung (14, 16) zur Trennung der Empfangsdaten in systematische Informationsdaten (x) und mehrere Redundanzdatenfolgen (y₁, y₂) vorgesehen ist.

3. Turbo-Code-Decoder nach Anspruch 1 oder 2,
**dadurch gekennzeichnet,**
**daß** die Datenfolgen-Trennungseinrichtung einen Multiplexer (16) aufweist, der die erste Redundanzdatenfolge (y₁) an den ersten Kanaldecodierer (18) und die zweite Redundanzdatenfolge an den zweiten Kanaldecodierer (24) abgibt.

4. Turbo-Code-Decoder nach einem der vorangehenden Ansprüche,
**dadurch gekennzeichnet,**
**daß** ein Zwischenspeicher (26) zum Zwischenspeichern der zweiten Redundanzdatenfolge (y₂) vorgesehen ist.

5. Turbo-Code-Decoder nach einem der vorangehenden Ansprüche,
**dadurch gekennzeichnet,**
**daß** die Turbo-Code-Codierschaltung (9) RSC-Codierer (39; 46) mit nachgeschalteten Punktierungseinrichtungen (41, 48), mindestens eine Turbo-Code-Verschachtelungsschaltung (44) sowie einen Multiplexer (37) aufweist.

6. Turbo-Code-Decoder nach einem der vorangehenden Ansprüche,
**dadurch gekennzeichnet,**
**daß** der geschätzte Kanalparameter das Signalrauschverhältnis ist.

7. Decodierverfahren zur Decodierung von turbo-codierten Empfangsdaten mit den folgenden Schritten:
(a) Gewichten der turbo-codierten Empfangsdaten mit mindestens einem geschätzten Kanalparameter;
(b) Erzeugen von Zuverlässigkeitsinformationsdaten in Abhängigkeit von in den Empfangsdaten enthaltenen systematischen Informationsdaten (x), einer ersten in den Empfangsdaten enthaltenen Redundanzdatenfolge (y₁) und einer Folge extrinsischer Informationsdaten (z) ;
(c) Verschachteln der erzeugten Zuverlässigkeitsinformationsdaten;
(d) Erzeugen von extrinsischen Informationsdaten (z) in Abhängigkeit von den verschachtelten Zuverlässigkeitsinformationsdaten sowie einer zweiten Redundanzdatenfolge (y₂) ;
(e) Erzeugen von Wahrscheinlichkeitsinformationsdaten in Abhängigkeit von den verschachtelten Zuverlässigkeitsinformationsdaten und der zweiten Redundanzdatenfolge (y₂) ;
(f) Entschachteln der Wahrscheinlichkeitsverhältnisdaten;
(g) Bilden einer Schätzwertdatenfolge aus den entschachtelten Wahrscheinlichkeitsverhältnisdaten mittels Schwellenwertentscheidung;
(h) Turbo-Codieren der gebildeten Schätzwertdatenfolge;
(i) Vergleichen der turbo-codierten Schätzwertdaten mit den turbo-codierten Empfangsdaten;
(j) iteratives Einstellen der Kanalparameter zur Gewichtung der turbo-codierten Empfangsdaten in Abhängigkeit von dem Vergleich zwischen den turbo-codierten Schätzwertdaten und den turbo-codierten Empfangsdaten.

## Claims

1. Turbo-code decoder with iterative channel parameter estimation for decoding turbo-coded received data, which comprise systematic information data and redundant data, with:
(a) a weighting circuit (4) for weighting the turbo-coded received data with at least one estimated channel parameter;
(b) a first channel decoder (18) to generate reliability information data depending on received systematic information data (x), a first redundant data string (y₁) and a de-interleaved extrinsic information data string (z) ;
(c) a turbo-code interleaver (22) to interleave the generated reliability information data;
(d) a second channel decoder (24) to generate the extrinsic information data string (z), which is de-interleaved by a first turbo-code de-interleaver (29) and fed back to the first channel decoder (18), and to generate probability ratio data, which are de-interleaved by a second turbo-code de-interleaver (31) and output to a threshold value decision circuit (33) to generate estimated value data, whereby the extrinsic information data string (z) and the probability ratio data are generated depending on the interleaved reliability information data and a second redundant data string (y₂),
(e) a turbo-code coding circuit (9) for turbo-coding of the generated estimated value data;
(f) and with a comparison circuit (11) which compares the turbo-coded estimated value data with the turbo-coded received data and, depending on the result of the comparison, iteratively sets the estimated channel parameters in order to weight the turbo-coded received data.

2. Turbo-code decoder according to Claim 1,
**characterized in that**
a data-separation device (14, 16) is provided to separate the received data into systematic information data (x) and a plurality of redundant data strings (y₁, y₂)

3. Turbo-code decoder according to Claim 1 or 2,
**characterized in that**
the data-string separation device has a multiplexer (16), which outputs the first redundant data string (y₁) to the first channel decoder (18) and the second redundant data string to the second channel decoder (24).

4. Turbo-code decoder according to one of the preceding claims,
**characterized in that**
a buffer memory (26) is provided for buffer storage of the second redundant data string (y₂).

5. Turbo-code decoder according to one of the preceding claims,
**characterized in that**
the turbo-code coding circuit (9) has RSC coders (39; 46) with downstream puncturing devices (41, 48), at least one turbo-code interleaving circuit (44) and a multiplexer (37).

6. Turbo-code decoder according to one of the preceding claims,
**characterized in that**
the estimated channel parameter is the signal-to-noise ratio.

7. Decoding method for decoding turbo-coded received data with the following steps:
(a) Weighting of the turbo-coded received data with at least one estimated channel parameter;
(b) Generation of reliability information data depending on received systematic information data (x) contained in the received data, a first redundant data string (y₁) contained in the received data and a sequence of extrinsic information data (z) ;
(c) Interleaving of the generated reliability information data;
(d) Generation of extrinsic information data (z) depending on the interleaved reliability information data and a second redundant data string (y₂) ;
(e) Generation of probability information data depending on the interleaved reliability information data and the second redundant data string (y₂);
(f) De-interleaving of the probability ratio data;
(g) Formation of an estimated value data string from the de-interleaved probability ratio data by means of threshold value decision-making;
(h) Turbo-coding of the formed estimated value data string;
(i) Comparison of the turbo-coded estimated value data with the turbo-coded received data;
(j) Iterative setting of the channel parameters in order to weight the turbo-coded received data depending on the comparison between the turbo-coded estimated data and the turbo-coded received data.

## Revendications

1. Décodeur de code turbo avec estimation itérative de paramètres de canal en vue du décodage de données reçues à code turbo qui comprennent des données d'informations systématiques et des données redondantes, comportant
(a) un circuit de pondération (4) pour pondérer les données reçues à code turbo avec au moins un paramètre de canal estimé ;
(b) un premier décodeur de canal (18) pour produire des données d'informations de fiabilité en fonction des données d'informations systématiques reçues (x), d'une première séquence de données redondante (y₁) et d'une séquence de données d'informations extrinsèques (z) désimbriquée ;
(c) un dispositif d'imbrication à code turbo (22) pour imbriquer les données d'informations de fiabilité produites ;
(d) un deuxième décodeur de canal (24) pour produire la séquence de données d'informations extrinsèques (z), qui est renvoyée, désimbriquée par un premier dispositif de désimbrication à code turbo (29), au premier décodeur de canal (18), et pour produire des données de taux de probabilité qui sont délivrées, désimbriquées par un deuxième dispositif de désimbrication à code turbo (31), à un circuit de décision à valeur de seuil (33) en vue de la génération de données de valeurs estimées, la production de la séquence de données d'informations extrinsèques (z) et des données de taux de probabilité s'effectuant en fonction des données d'informations de fiabilité imbriquées et d'une deuxième séquence de données redondante (y₂) ;
(e) un circuit codeur à code turbo (9) pour effectuer un codage avec code turbo des données de valeurs estimées générées ;
(f) et un circuit comparateur (11) qui compare les données de valeurs estimées à code turbo aux données reçues à code turbo et qui, en fonction du résultat de la comparaison, règle par itération les paramètres de canal estimés pour la pondération des données reçues à code turbo.

2. Décodeur de code turbo selon la revendication 1,
**caractérisé par le fait qu'**un dispositif séparateur de données (14, 16) est prévu pour séparer les données reçues en données d'informations systématiques (x) et en plusieurs séquences de données redondantes (y₁, y₂).

3. Décodeur de code turbo selon la revendication 1 ou 2,
**caractérisé par le fait que** le dispositif séparateur de séquences de données comporte un multiplexeur (16) qui fournit la première séquence de données redondante (y₁) au premier décodeur de canal (18) et la deuxième séquence de données redondante (y₂) au deuxième décodeur de canal (24).

4. Décodeur de code turbo selon l'une des revendications précédentes,
**caractérisé par le fait qu'**une mémoire intermédiaire (26) est prévue pour la mémorisation temporaire de la deuxième séquence de données redondante (y₂).

5. Décodeur de code turbo selon l'une des revendications précédentes,
**caractérisé par le fait que** le circuit codeur à code turbo (9) comporte des codeurs RSC (39 ; 46) avec dispositifs de ponctuation branchés du côté aval (41, 48), au moins un circuit d'imbrication à code turbo (44) ainsi qu'un multiplexeur (37).

6. Décodeur de code turbo selon l'une des revendications précédentes,
**caractérisé par le fait que** le paramètre de canal estimé est le rapport signal/bruit.

7. Procédé de décodage pour décoder des données reçues à code turbo avec les étapes suivantes :
(a) pondération des données reçues à code turbo avec au moins un paramètre de canal estimé ;
(b) production de données d'informations de fiabilité en fonction de données d'informations systématiques reçues (x) contenues dans les données reçues, d'une première séquence de données redondante (y₁) contenue dans les données reçues et d'une séquence de données d'informations extrinsèques (z) ;
(c) imbrication des données d'informations de fiabilité produites ;
(d) production de données d'informations extrinsèques (z) en fonction des données d'informations de fiabilité imbriquées ainsi que d'une deuxième séquence de données redondantes (y₂) ;
(e) production de données d'informations de probabilité en fonction des données d'informations de fiabilité imbriquées et de la deuxième séquence de données redondantes (y₂) ;
(f) désimbrication des données de taux de probabilité ;
(g) formation d'une séquence de données de valeurs estimées à partir des données de taux de probabilité imbriquées au moyen d'une décision à valeur de seuil ;
(h) codage avec code turbo de la séquence de données de valeurs estimées formée ;
(i) comparaison des données de valeurs estimées à code turbo aux données reçues à code turbo ;
(j) réglage itératif des paramètres de canal pour la pondération des données reçues à code turbo en fonction de la comparaison entre les données de valeurs estimées à code turbo et les données reçues à code turbo.
